# EUROPEAN PATENT SPECIFICATION

(11) **EP 1 433 196 B1**
(45) Date of publication and mention of the grant of the patent: **14.03.2007**
(21) Application number: 03788307.1
(22) Date of filing: 31.07.2003
(51) Int. Cl.: H01L 21/28, H01L 29/49

(54) **APPARATUS TO PREVENT LATERAL OXIDATION IN A TRANSISTOR UTILIZING AN ULTRA THIN OXYGEN-DIFFUSION BARRIER**
VORRICHTUNG ZUM VERHINDERN DER SEITLICHEN OXIDATION IN EINEM TRANSISTOR UNTER VERWENDUNG EINER ULTRADÜNNEN SAUERSTOFFDIFFUSIONSBARRIERE
APPAREIL, PREVENANT L'OXYDATION LATERALE D'UN TRANSISTOR AU MOYEN D'UNE BARRIERE ULTRA MINCE EMPECHANT LA DIFFUSION DE L'OXYGENE

(30) Priority: 14.08.2002 US 219726
(43) Date of publication of application: 30.06.2004
(73) Proprietor: INTEL CORPORATION, Santa Clara, CA 95202 (US)
(72) Inventor: ARGHAVANI, Reza, CA 95066 (US); STOKLEY, Patricia, Aloha, OR 97006 (US); CHAU, Robert, Beaverton, OR 97007 (US)
(74) Representative: Goddar, Heinz J.
(86) International application number: PCT/US2003/024108
(87) International publication number: WO 2004/017393

(56) References cited:
- US-A1- 2002 047 168
- US-B1- 6 172 407
- US-B1- 6 225 168
- US-B1- 6 232 179
- US-B1- 6 281 075
- US-B1- 6 348 709
- US-B1- 6 383 873

## Description

### FIELD

The present invention relates generally to the field of semiconductor technology and, more specifically, to preventing lateral oxidation in transistors utilizing an ultra thin oxygen-diffusion barrier.

### BACKGROUND

Typically, in semiconductor processes, a transistor device includes a gate characterized by a gate dielectric overlying a substrate, and a gate electrode overlying the gate dielectric. The gate electrode is an electrically conductive material, such as doped polysilicon or metal. The gate dielectric has traditionally been a low-k dielectric material, such as silicon dioxide (SiO2).

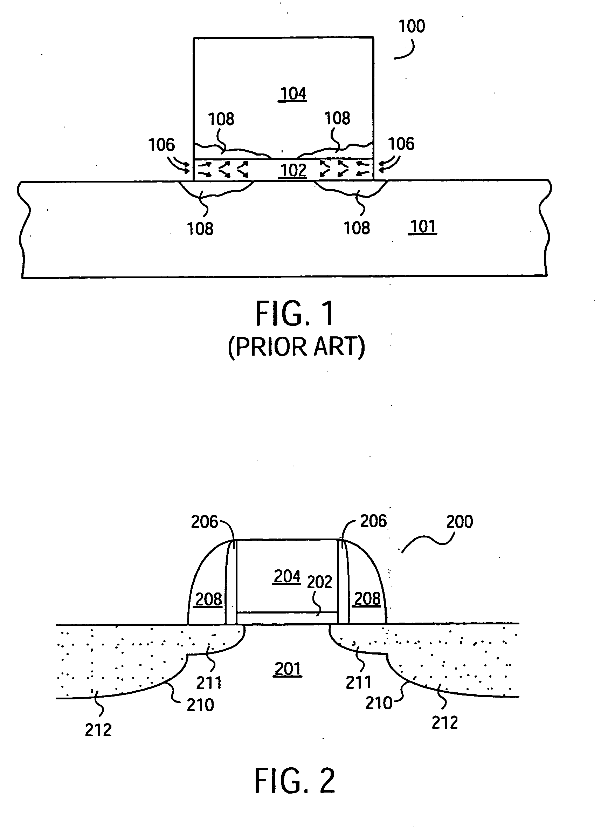

However, due to the great need for smaller transistor devices, the low-k dielectric has had to become increasingly thinner. At a certain thinness, however, the low-k gate dielectric begins to loose its dielectric qualities. Consequently, a more conventional practice has been to replace the low-k dielectric with a high-k dielectric. A high-k dielectric can provide greater dielectric qualities at a lower thickness than low-k dielectrics. Unfortunately, high-k dielectrics are not without their problems as well. For example, high-k dielectrics are highly permeable to oxygen diffusion. Figure 1 illustrates the potential effects of oxygen diffusion through a high-k gate dielectric 102 in a transistor gate structure 100 according to the prior art. Referring to **Figure 1,** a high-k gate dielectric 102 overlies a silicon substrate 101. Over the high-k gate dielectric 102 is formed a gate electrode 104, also known as a gate terminal, made of an electrically conductive material, such as doped polysilicon. Subsequently, processes such as lithographies, anneals, and spacer depositions can introduce oxygen 106, either as part of the process or unintentionally, as ambient oxygen, which diffuses laterally (horizontally) into the high-k gate dielectric 102 and oxidizes portions of the underlying silicon substrate 101 and the overlying polysilicon gate electrode 104, to form undesirable SiO2 deposits 108.

These SiO₂ deposits 108 are very undesirable because they effectively increase the thickness of the gate dielectric 102 and decrease the thickness of the gate electrode 104. Furthermore, the SiO₂ deposits 108 reduce the net dielectric constant of the gate dielectric 102, increasing the capacitance of the circuit. Consequently, the benefit of utilizing a high-k gate dielectric is lost. Additionally, the SiO₂ deposits 108 are undesirable because they attack the area of the silicon substrate 101 where the channel will be, thus detrimentally affecting the performance of the transistor that will be formed from the gate structure 100.
The prior art includes a method of fabricating a semiconductor device comprising a MIS field-effect transistor having a lightly doped drain (LDD) structure, in which the edge portions of the gate insulation layer are not damaged, as well as a semiconductor device comprising a MIS field-effect transistor that is fabricated by this method.
One such semiconductor device can be fabricated by a method including forming a field oxide layer for separating elements on the main surface of a silicon substrate. Then forming a gate oxide layer on the main surface of the silicon substrate. The thickness of the gate oxide layer is between a few nm and 100 nm. Then forming a polysilicon layer over the entire main surface of the silicon substrate. Phosphorous is included within the polysilicon layer as an impurity, to ensure that the polysilicon layer is conductive. Then applying a photoresist over the polysilicon layer and subjecting the photoresist to given patterning. The thus patterned photoresist is used as a mask for selective etching of the polysilicon layer by anisotropic etching, to form the gate electrode. Generally, the method used for the anisotropic etching of the polysilicon layer is such that a gas such as freon or a halogen flows at a reduced pressure on the order of a few tens of mTorr, a high-frequency plasma is generated therefrom, and etching is performed by that high-frequency plasma.
For one such method, the silicon nitride layer is formed over the entire main surface of the silicon substrate to cover the gate oxide layer and the gate electrode. A CVD method using dichloramine and ammonia as material gases could be used by way of example as the method of forming the silicon nitride layer. The silicon nitride layer is etched back by anisotropic etching. This leaves the silicon nitride layer at positions shielding the side surfaces of the gate electrode and the gate oxide layer. The method of performing anisotropic etching on the silicon nitride layer could be one in which a freon type of gas flows at a reduced pressure of, for example, approximately 0.1 Torr (13 Pa), a high-frequency plasma is generated therefrom, and etching is performed by that high-frequency plasma (1 Torr = 133 Pa).
An example of such a method and a semiconductor device formed thereby can be found in U.S. Patent Application No. 20020047168 to Toshihiko.
The invention provides an transistor according to claim 1.

### BRIEF DESCRIPTION OF THE DRAWINGS

The present invention is illustrated by way of example and should not be limited by the figures of the accompanying drawings in which like references indicate similar elements and in which:

Figure 1 illustrates the potential effects of oxygen diffusion through a high-k gate dielectric in a transistor gate structure according to the prior art.

Figure 2 illustrates a transistor with a thin oxygen-diffusion barrier, which is an example helpful for understanding the invention.

**Figures 3A - 3M** illustrate a method of forming a transistor with a thin oxygen-diffusion barrier to prevent lateral oxygen diffusion through an oxygen-permeable gate dielectric, according to one embodiment of the invention.

### DETAILED DESCRIPTION

Described herein is a method and apparatus to prevent lateral oxidation in transistors. In the following description numerous specific details are set forth. One of ordinary skill in the art, however, will appreciate that these specific details are not necessary to practice embodiments of the invention. While certain exemplary embodiments have been described and shown in the accompanying drawings, it is to be understood that such embodiments are merely illustrative and not restrictive of the current invention, and that this invention is not restricted to the specific constructions and arrangements shown and described since modifications may occur to those ordinarily skilled in the art. In other instances well-known semiconductor fabrication processes, techniques, materials, equipment, etc., have not been set forth in particular detail in order to not unnecessarily obscure embodiments of the present invention.

According to embodiments of the invention described herein, a method and apparatus are described to form an oxygen-resistant diffusion barrier on the sides of a transistor. The oxygen-resistant diffusion barrier prevents oxygen from diffusing laterally into the sidewalls of a gate-dielectric that has very low resistance to oxygen diffusion, or in other words, that has a high permeability to oxygen diffusion. By preventing lateral diffusion of oxygen, the underlying substrate, or the overlying gate electrode, is protected from undesireable oxidation. Application is particular advantageous for high-k gate dielectrics since most high-k gate dielectrics are highly permeable to oxygen diffusion. Consequently, an advantage of the oxygen-resistant diffusion barrier is that transistors can have very thin gate dielectrics yet not suffer from lateral oxidation that normally occurs with high-k gate dielectrics. As a result, integrated circuitry can be formed smaller without experiencing loss in performance or reliability.

**Figure 2** illustrates a transistor 200 with a thin oxygen-diffusion barrier 206, according to one embodiment of the invention. Referring to **Figure 2,** a transistor 200 is formed on a silicon substrate 201. An oxygen- permeable gate dielectric 202, such as a high-k dielectric being highly permeable to oxygen diffusion, is formed on the surface of the substrate 201 and a gate electrode 204 is in turn formed on the oxygen-permeable gate dielectric 202. A thin oxygen-diffusion barrier 206 is formed on the sidewalls of the gate electrode 204 and on the sidewalls of the oxygen-permeable gate dielectric 202. The transistor 200 also includes a pair of thick sidewall spacers 208 formed adjacent to the outside edges of the oxygen-diffusion barrier 206. The transistor 200 includes a pair of source/drain regions 210 each comprising a pair of tips or source/drain extensions 211 and a deep junction source/drain contact region 212.

Still referring to **Figure 2,** the thin oxygen-diffusion barrier 206 is made of a material that is highly resistant to the diffusion of oxygen. Conventionally, during processing of a transistor, certain processes could be performed that would incidentally expose the oxygen-permeable gate dielectric 202 to oxygen, usually during an oxidation process or via other processes containing ambient oxygen. The oxygen would easily pass through the oxygen-permeable gate dielectric 202 and oxidize the underlying substrate 201 or the overlying gate electrode 204. The oxidation would form undesirable silicon dioxide deposits that would adversely affect the performance of the transistor, perhaps even rendering the transistor inoperable. The thin oxygen-diffusion barrier 206, however, covers and seals the sidewalls of the oxygen-permeable gate dielectric 206 and prevents the lateral diffusion of oxygen into the oxygen-permeable gate dielectric 206.

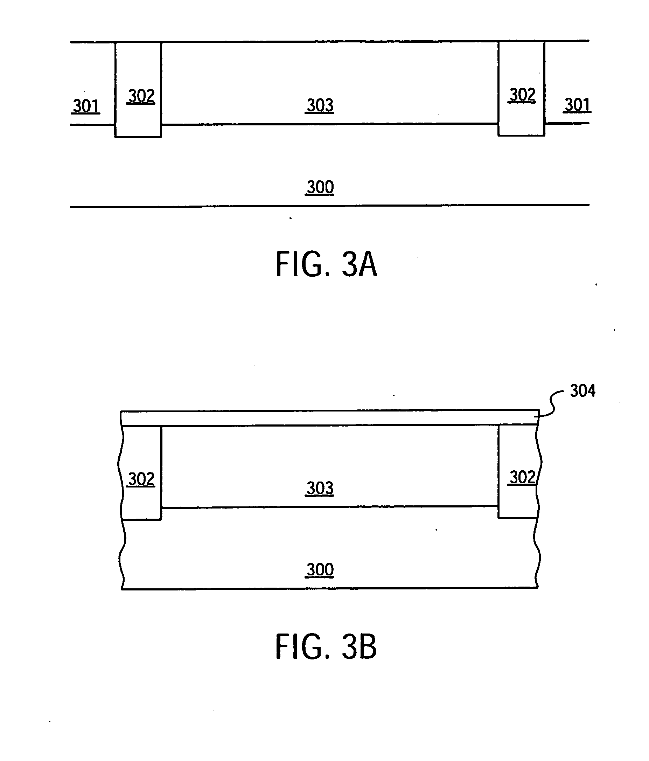

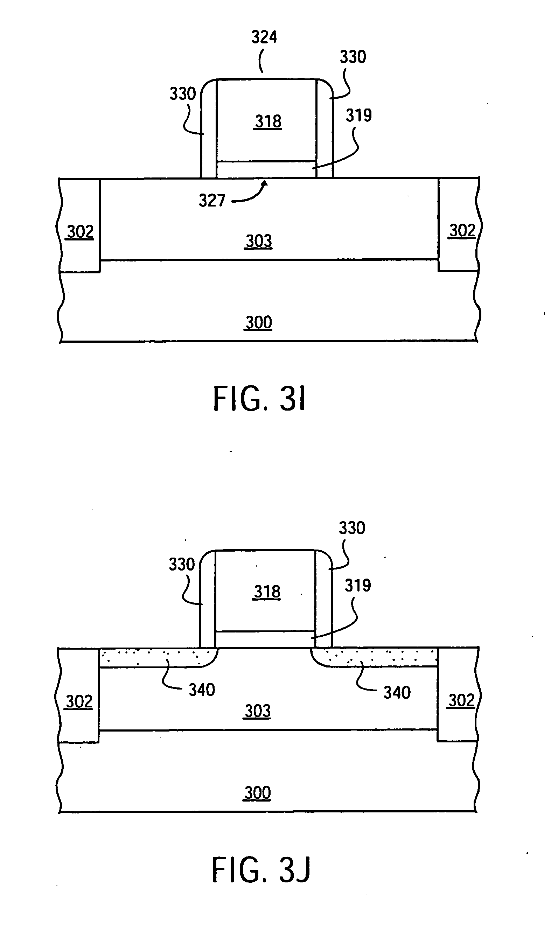

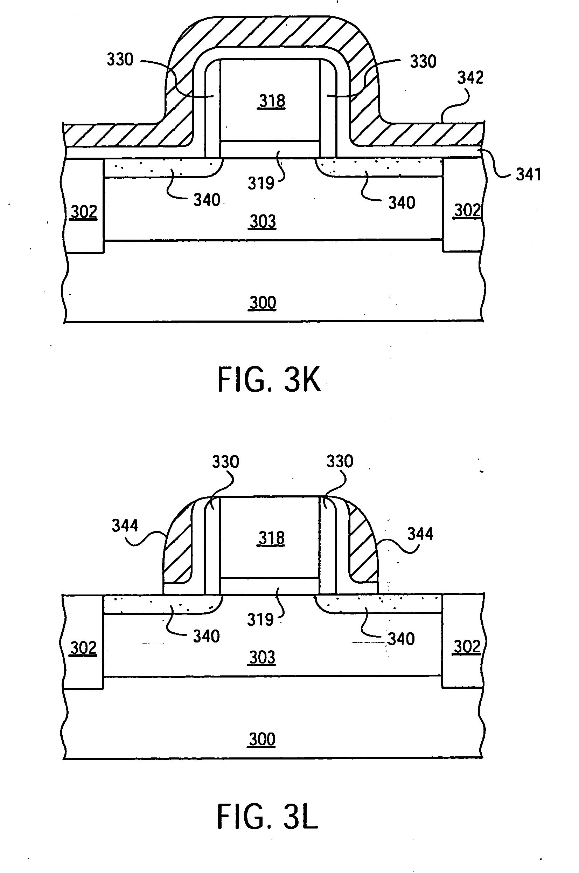

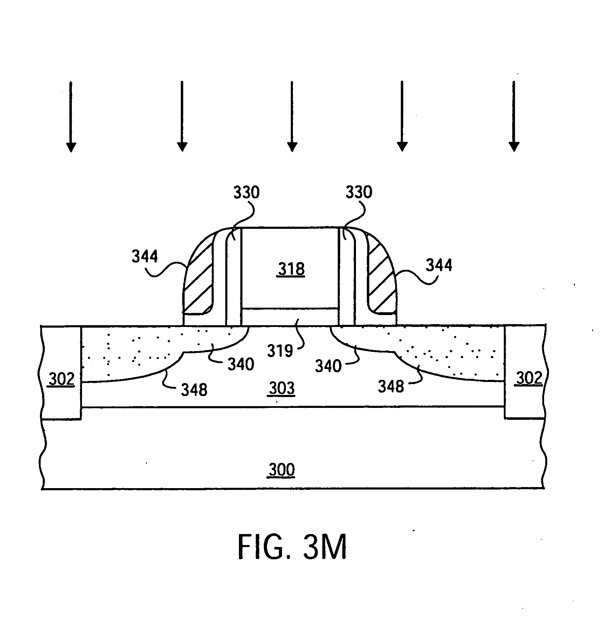

**Figures 3A - 3M** illustrate a method of forming a transistor with a thin oxygen-diffusion barrier to prevent lateral diffusion of oxygen through an oxygen-permeable gate dielectric, according to one embodiment of the invention. Referring to **Figure 3A**, a plurality of field isolation regions 302 are formed in a substrate 300. The term "substrate" encompasses a semiconductor wafer, such as monocrystalline silicon, as well as structures that have one or more insulative, semi-insulative, conductive, or semiconductive layers and materials. Thus, for example, the term embraces silicon-on-insulator, silicon-on-sapphire, and other advanced structures. Isolation regions 302 may be shallow trench isolation (STI) or deep trench isolation regions formed by etching a trench into the substrate 300 and then filling the trench with a deposited oxide, nitride, or other dielectric material. Field isolation regions 302 may also be formed utilizing other methods, such as LOCOS, recessed LOCOS, or silicon on insulator (SOI) methods.

The plurality of isolation regions 302 isolate a well 303 of one type conductivity from wells 301 of other type conductivity. For example, well 303 may be a region of a p-type conductivity while wells 301 may be regions of n-type conductivity, or vice-versa. A well of p-type conductivity may be formed by a first implant of boron atoms at a dose of 3.0x10¹³/cm² at an energy of 230 keV followed by a second implant of boron ions at a dose of 4.2x10¹³/cm² and an energy of 50 keV into substrate 300 in order to produce a p-well having a concentration of 7.0×10¹⁷/cm³. A well of n-type conductivity may be formed by a first implant of phosphorous atoms at a dose of 4x10¹³/cm² and an energy of 475 keV, a second implant of phosphorous atoms at a dose of 2.5x10¹²/cm² at an energy of 60keV, and a final implant of arsenic atoms at a dose of 1.10¹³/cm² at an energy of 180 keV into a silicon substrate having a concentration of 1x10¹⁶/cm³ in order to produce an n-well having an n-type concentration of approximately 7.0x10¹⁷/cm³. It is to be appreciated that p-type conductivity regions and n-type conductivity regions may be formed by other means well known to those of ordinary skill in the art.

The method may continue, as shown in **Figure 3B,** with blanket depositing an electrically insulative ("dielectric") layer 304 on the substrate 300 and on isolation regions 302, the dielectric layer 304. being highly permeable to the diffusion of oxygen, or, in other words, an oxygen-permeable dielectric layer 304. In one embodiment of the invention, the oxygen-permeable dielectric layer 304 is a high-k dielectric material and may be deposited between 2 Å to 50 Å thick. (10Å = 1nm). Conventional techniques for blanket depositing a layer of high-k dielectric material include sputter deposition or evaporation techniques.

The term "high-k" is a relative term that refers to a material with a dielectric constant (k) substantially higher than that of silicon dioxide (SiO₂), or in other words substantially higher than k=3.9. Exemplary high-k materials used in the formation of integrated devices include metal oxides (Al₂O₃, ZrO₂, HfO₂, TiO₂, Y₂O₃, La₂O₃, etc.), ferroelectrics (PZT, BST, etc.), amorphous metal silicates (Hf, Zr), amorphous silicate oxides (HfO₂, ZrO₂), and paralectrics (BaₓSr₁₋ₓTiO₃, PbZrₓTi₁₋ₓO₃).

High-k dielectrics are very useful to the formation of transistors because of the effective electrically insulative properties of the high-k material compared to its physical thickness. The high dielectric qualities allow high-k dielectric materials to be deposited very thin yet still possess very good effective electrical "thickness" - in many cases much greater than the effective electrical thickness of SiO₂ at an equivalent physical thickness.

Despite the many advantages of utilizing a high-k dielectric in the formation of a transistor, however, many classes of high-k dielectrics have an unfortunate disadvantage, they are highly permeable to oxygen diffusion, or in other words, oxygen molecules (or molecules of oxygen compounds) can easily pass through pores in the high-k dielectric material. Consequently, according to one embodiment of the invention, the oxygen-permeable dielectric layer 304 may synonymously be referred as a high-k dielectric. However, other embodiments of the invention may utilize other dielectric materials that are not necessarily high-k materials, but that are still highly permeable to oxygen diffusion.

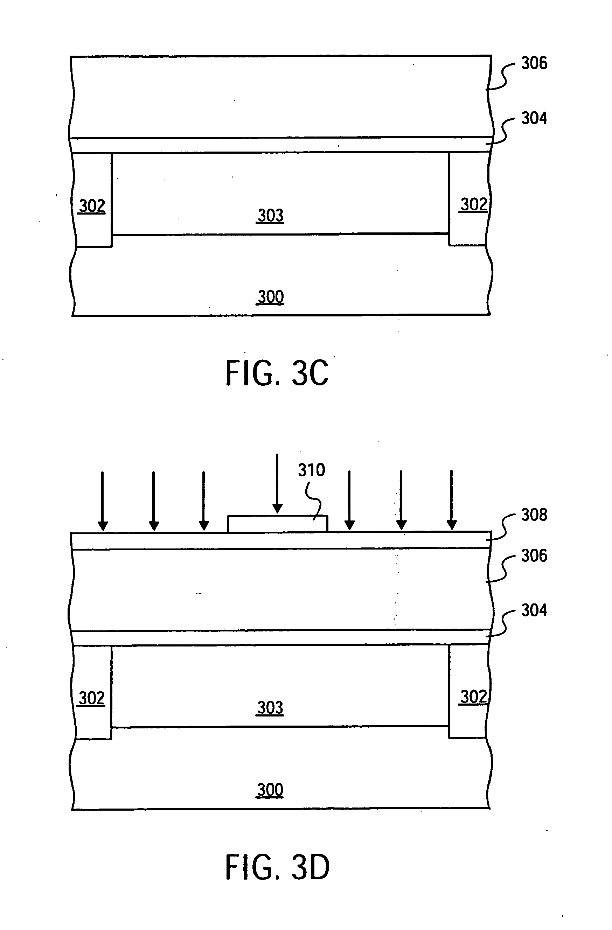

The method may continue, as shown in Figure 3C, with blanket depositing an electrically conductive material 306 over the oxygen-permeable dielectric layer 304, to a thickness scaled with the technology. In one embodiment of the invention the electrically conductive material 306 is polycrystalline silicon, or polysilicon, and is deposited to a thickness of between approximately 600 Å to 2000 Å, 1600 Å being preferable. Conventional polysilicon blanket deposition processes are well known in the art, including chemical vapor deposition (CVD) and physical vapor deposition (PVD). Such deposition processes typically take place at temperatures in the range of 600 to 650 °C, however these deposition processes may take place at higher temperatures. Silane or gas streams containing N₂ or H₂, at 100%, may be used in the polysilicon deposition process. The electrically conductive layer 306 can be ion implanted to the desired conductivity type and level prior to, or after, patterning. In other embodiments of the invention, other materials may be utilized in conjunction with, or in place of, polysilicon, such as metal, metal alloy, and metal oxide, single crystalline silicon, amorphous silicon, silicide, or other materials well known in the art to form a gate electrode.

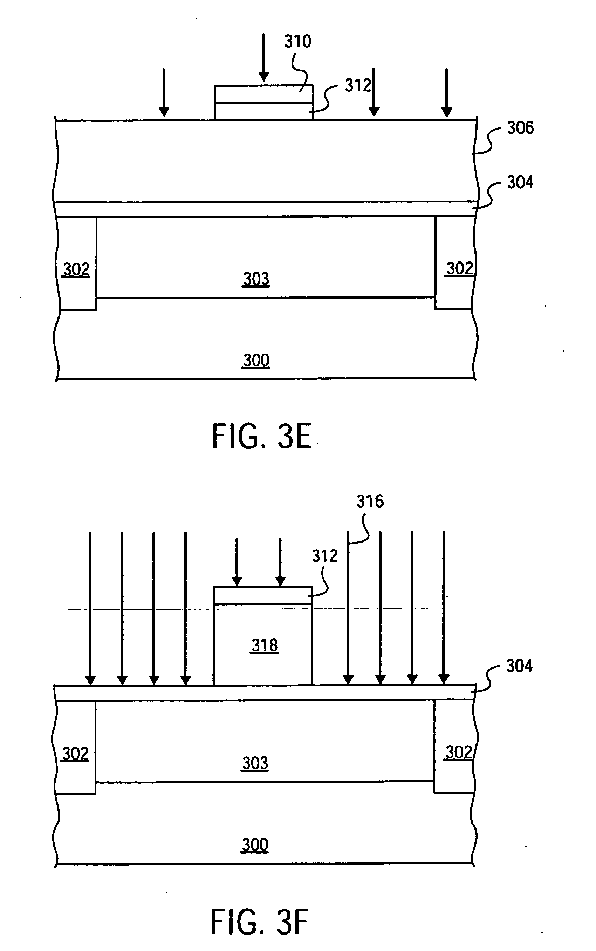

The method may continue with forming a hard-mask 312 on the electrically conductive layer 306, as shown in **Figures 3D - 3E**. Several well-known methods may be employed for forming a hard-mask on an electrically conductive layer 306. In the embodiment of the invention shown in **Figure 3D,** the hard-mask 312 may be formed by depositing a hard mask layer 308, such as a nitride layer, via a chemical vapor deposition (CVD) over the electrically conductive layer 306. A typical photolithography process can then be performed including the well-known steps of masking, exposing, and developing a photoresist layer to form a photoresist mask 310, shown in **Figure 3D.** Then, as shown in **Figure 3E,** the pattern of the photoresist mask 310 is transferred to the masking layer 308 by etching the masking layer 308 to the top of the electrically conductive layer 306, using the photoresist mask 310 to align the etch, thus producing a hard-mask 312 over the electrically conductive layer 306.

The method continues, as shown in **Figure 3F,** with removing the photoresist mask 310 and etching the electrically conductive layer 306 down to the top of the oxygen-permeable dielectric layer 304 using the hard-mask 312 to align the etch, thus creating a conductive structure 318, also known as a gate electrode or gate terminal, underneath the hard-mask 312. The etchant 316 should etch the electrically conductive layer 306, but not the hard-mask 312 or the oxygen-permeable dielectric layer 304. To prevent lateral etching into the sidewalls of the gate electrode 318, a dry etch is preferable utilizing a Chlorine based chemistry. A hot phosphorous etch may then be applied to remove the hard-mask 312.

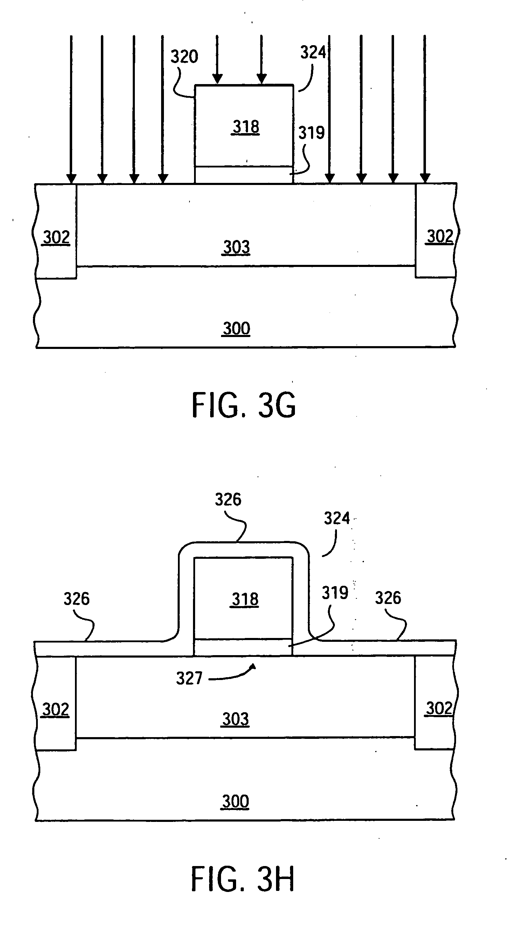

Next, the method may continue, as shown in **Figure 3G,** with etching the oxygen-permeable dielectric layer 304 to the top of the substrate 300 and to the tops of the isolation regions 302. The etch chemistry should be such that the oxygen-permeable dielectric layer 304 is etched but neither the substrate 300, the gate electrode 318, nor the isolation regions 302 are etched. The etch leaves a portion 319 of the oxygen-permeable dielectric layer 304 directly underneath the gate electrode 318. This portion 319 of the dielectric layer 304 is also known as a gate dielectric and is the same material as the oxygen-permeable dielectric layer 304. The portion 319 of the oxygen-permeable dielectric layer underneath the gate electrode 318 will herein be referred to as a "gate dielectric", or "oxygen-permeable gate dielectric". In one embodiment of the invention, as described in further detail above, the oxygen-permeable gate dielectric 319 comprises a high-k dielectric material. The gate electrode 318 aligns the etch so that the sidewalls of the oxygen-permeable gate dielectric 319 are vertically aligned to the sidewalls of the gate electrode 318. To minimize the risk of etching the substrate, a wet etch may be preferable to a dry etch. In one embodiment of the invention an exemplary etch chemistry may include a 50:1 HF etch for 40 seconds, or until the oxygen-permeable dielectric layer 304 is completely removed from the surface of the isolation regions 302 and from the surface the substrate 300, except for directly underneath the gate electrode 318. Because of the highly diffusible nature of the oxygen-permeable gate dielectric 319, the etching of the oxygen-permeable dielectric layer 304 should be careful not to introduce oxygen, whether directly as part of the process since the oxygen-permeable gate dielectric 319 will be exposed and the oxygen would diffuse laterally into the oxygen-permeable gate dielectric 319.

The gate electrode 318 and the oxygen-permeable gate dielectric 319 together define a composite structure 324, sometimes known as a gate structure, or gate, of an integrated device, such as a transistor. As shown in Figure 3G, the sidewalls of the gate structure 324 begin at the top edge 320 of the gate electrode 319 and extend downward along the entire length of the sidewalls of both the gate electrode 318 and the oxygen-permeable gate dielectric 319.

Next, as shown in **Figure 3H,** a thin oxygen-resistant layer 326 is blanket deposited over the top of the gate structure 324 and along the entire length of the sides of the gate structure 324, including on (touching) the entire length of the sidewalls of the gate electrode 318 and the gate dielectric 319. At the same time, the thin-oxygen resistant layer 326 is deposited on top of any exposed portion of the substrate 300 or isolation regions 302. The oxygen-resistant layer 326 is a material that should be resistant to the diffusion of oxygen and also does not contain oxygen molecules that may interfacially diffuse into the touching oxygen-permeable gate dielectric 319. In other words, the oxygen-resistant layer 326 is highly resistant to oxygen diffusion and is free from diffusible oxygen. An exemplary material for the oxygen-resistant layer 326 is a nitride, such as silicon nitride, boron nitride, magnesium nitride, etc., formed by any well-known process of depositing a thin nitride film. Exemplary blanket deposition processes include a Bistertiarybutylaminosilane (BTBAS) process, an atomic layer deposition (ALD) process, or a hotwall process (ammonia + Silane).

During the formation of the thin oxygen-resistant layer 326, just as during the etching of the oxygen-permeable dielectric layer 304 described above, care should be taken to prevent oxygen from being introduced into the process when the oxygen-permeable gate dielectric 319 may be exposed including during the patterning of the oxygen-permeable dielectric layer 304 and during the formation of the thin oxygen-resistant layer 326. Oxygen exposure may be substantially limited by performing all, or part, of the method in a substantially oxygen-free environment, such as a vacuum. However, even with best efforts, minute amounts of ambient oxygen may inadvertently be introduced during the process and may laterally diffuse into the oxygen-permeable dielectric layer 304. Thus, the method of depositing the thin oxygen-resistant layer 326 may further be optimized to prevent lateral oxidation, or, in other words, to prevent oxidation to the area 327 of the substrate 300 underneath the oxygen-permeable gate dielectric 319 by lateral diffusion of oxygen. For example, a low-temperature method of depositing the oxygen-resistant layer 326 may be advantageous since oxidation of the substrate 300 is less likely to occur at low temperatures (e.g., less than approximately 650°C). The low temperature reduces the chances of even minor oxidation to the portion 327 of the substrate 300 if, by chance, a small portion of oxygen is somehow introduced. A BTBAS process is advantageous because it can be performed at a low temperature, between approximately 550° C - 650° C, compared to some other methods, such as a hotwall process, which is typically performed at a temperature of approximately 800° C. Therefore, in one embodiment of the invention, a BTBAS process may be utilized to deposit the oxygen-resistant layer 326.

An exemplary BTBAS process is a CVD process that may include heating at least the surface of the substrate 300, the sides of the oxygen-permeable gate dielectric 319, and the sides and top of the gate electrode 318 to a temperature between approximately 500° C to 650° C, preferably 600° C. Then, at a pressure of approximately 600 Torr, simultaneously flowing molecular nitrogen (N₂) at approximately 2,000 standard cubic centimeters per second (sccm), ammonia (NH₃) at approximately 200 sccm, and BTBAS at approximately 800 milligrams per minute (mgm). The N₂, NH₃, and BTBAS combine to form silicon nitride at a rate of approximately 1 Å per second. The BTBAS process hermetically seals the oxygen-resistant layer 326 to the sides of gate electrode 318 and the gate dielectric 319.

One ordinarily skilled in the art will recognize that in some embodiments of the invention, other low temperature processes of depositing the thin oxygen-resistant layer 326 may also be advantageously utilized. At the same time, it should be important to note that a low-temperature process is advantageous to limit oxidation of the area 327 if some oxygen has somehow laterally diffused into the oxygen-permeable gate dielectric 319, but high-temperature methods may also be utilized in depositing the oxygen-resistant layer 326 if no oxygen has laterally diffused into the oxygen-permeable gate dielectric 319. Furthermore, high-temperature methods may also be utilized if only a minor amount of oxygen has laterally diffused into the oxygen-permeable gate dielectric 310 since minor oxidation may be acceptable to a certain degree.

In one embodiment of the invention, the thin oxygen-resistant layer 326 should be deposited thick enough to act as a diffusion barrier to oxygen, to prevent oxygen from diffusing laterally into the sidewalls of the oxygen-permeable gate dielectric 319 during subsequent processes. However, the thin oxygen-resistant layer 326 should not be deposited so thick that it will interfere with the subsequent formation of tip-implants, described in detail further below. Therefore, in one embodiment of the invention, the thin oxygen-resistant layer 326 is deposited between approximately 2Å to 300Å.

Next, as shown in **Figure 3I**, the thin oxygen-resistant layer 326 is etched using a substantially vertical, or anisotropic, etch technique. An anisotropic etch technique uses an etch chemistry that etches primarily in the vertical (anisotropic) direction, although a small amount of horizontal (isotropic) etching may occur. An exemplary chemistry for the etch may be a standard nitride etch with a carbon tetraflouride (CF₄) chemistry (e.g., CF₄H₂, or CF₄ + O₂ in a plasma generator). The anisotropic etch removes the thin oxygen-resistant layer 326 from the top of the gate electrode 318 as well as from the top surface of the isolation regions 302 and from most of the top surface of the substrate 300 except immediately to either side of the gate structure 324. The anisotropic etch, however, leaves a portion 330 of the oxygen-resistant layer 326 along the entire length of the sidewalls of both the gate electrode 318 and the oxygen-permeable gate dielectric 319.

The portion 330 may be referred to as a "thin oxygen-resistant spacer" since it is similar in appearance to conventional thick spacers typically formed during the fabrication of a transistor. However, the typical function of a thick spacer is to prevent vertical doping of impurities to certain regions of the substrate, whereas the function of the portion 330 left on the sidewalls is to prevent the lateral diffusion of oxygen into the oxygen permeable gate dielectric 319. In addition, typical thick spacers may not necessarily be oxygen-resistant, may contain interfacially diffusive oxygen, and are formed much thicker. Consequently, herein the portion 330 left on the sidewalls will be referred to as a "thin oxygen-diffusion barrier" since one of its functions is to act as a barrier to oxygen diffusion.

The thin oxygen-diffusion barrier 330 covers and hermetically seals the sidewalls of the oxygen-permeable gate dielectric 319. If the thin oxygen-diffusion barrier 330 were not present, oxygen (O₂, O₃, etc.) that is directly applied during a subsequent process, or ambient oxygen that exists in the atmosphere, would pass laterally through fine pores in the oxygen-permeable gate dielectric 319 and into the silicon substrate 300 underneath the oxygen-permeable gate dielectric 319, oxidizing the silicon substrate in the channel area 327 forming silicon dioxide deposits. The silicon dioxide deposits would affect the eventual performance of the integrated device by interfering with current flow through the channel 327. At the same time, if not for the a thin oxygen-diffusion barrier 330 oxygen would laterally diffuse into the oxygen-permeable gate dielectric 319 into the touching gate electrode 318 directly above the oxygen-permeable gate dielectric 319. If the gate electrode 318 is made of a material that can be oxidized, such as polysilicon, silicon dioxide deposits may also form at the interface between the gate electrode 318 and the gate dielectric 319. Since silicon dioxide is a dielectric, formation of silicon dioxide deposits in the substrate 300, or in the gate electrode 318, would increase the physical thickness of the gate dielectric 319. Furthermore, since silicon dioxide has a relatively low-k dielectric value compared to that of the oxygen-permeable gate dielectric 319, the effective electrical k value of the gate dielectric 319 would dramatically decrease, essentially negating the advantageous purposes for using a high-k dielectric material.

Another advantage of the thin oxygen-diffusion barrier 330 is that the edges of the gate electrode 318 touching the oxygen-resistant spacers 330 are sealed as well. The seal of the thin oxygen-diffusion barrier 330 to the edges of the gate electrode 318 and to the edges of the oxygen-permeable gate dielectric 319 help to improve the hot electron lifetime of the transistor.

Immediately after forming the oxygen-diffusion barrier, the method continues, as shown in **Figure 3J**, with forming tips 340, or shallow source/drain extensions, by utilizing a tip implant process. Numerous well-known techniques may be utilized to form tips 340 in the substrate 300. In one embodiment of the invention, the substrate 300 is doped with ions having an opposite conductivity to that of the conductivity of the well 303. For example, if well 303 had a p-type conductivity, then the tip implant would include implanting n-type conductivity ions, such as arsenic ions, into the top of the substrate 300 to form conventional N-tip regions. If however, the well 303 had an n-type conductivity, then the tip implant would include implanting p-type conductivity ions, such as boron ions, into the top of the substrate 300 to form convention P-tip regions. The gate electrode 318 protects the substrate region beneath the gate dielectric 319 from being implanted with ions.

The dose of the implantation is lower than that used to form deep source/drain junctions described in further detail below. For example, in one embodiment of the invention, the n-type conductivity ions may be deposited with a dose in the range of approximately 1x10¹⁵ ions/cm². In addition, to ensure that the tips 340 are formed to a shallow depth, the implant energy should be low, for example around 10 keV.

In one embodiment of the invention, the ions are implanted at a directly vertical angle (90°) forming tips 340 that are in alignment with the outside edges of the oxygen-diffusion barrier 330. A rapid thermal process (RTP) anneal may then be performed to drive the tips 340 underneath the oxygen-diffusion barrier 340 and partially underneath the oxygen-permeable gate dielectric 319.

One ordinarily skilled in the art, however, will recognize that other techniques may be performed to implant the shallow tips 340 at an angle other than 90°. An angled ion implantation may require a slightly higher implant energy since the angle of the ion implantation may require the ions to be implanted through the lower portions of oxygen-diffusion barrier 340 or the oxygen-permeable gate dielectric 319 to reach the substrate underlying the oxygen-diffusion barrier 340 or the oxygen-permeable gate dielectric 319.

Next, as shown in **Figures 3K - 3L,** the method continues by forming thick spacers 344 adjacent to, and touching the outer sidewalls of the thin oxygen-diffusion barrier 330. Thick spacers 344 may consist of silicon nitride or may be a combination of silicon nitride and silicon oxide. In one embodiment of the invention, the thick spacers 344 are an oxide/nitride/oxide (ONO) composite formed by a rapid thermal oxidation process. In another embodiment of the invention, thick spacers 344 are a nitride/oxide composite. The nitride/oxide spacers may be formed by blanket depositing a thin, approximately 50-100Å, oxide layer 341 over the isolation regions 302, the tip implants 340, the thin oxygen-diffusion barrier 330, and the gate electrode 318, as shown in **Figure 3K.** The blanket deposition of the oxide layer 341 may include any well-known CVD process, including a BTBAS process. It is advantageous to keep the deposition temperature low, preferably at 650°C so that the thermal energy does not disturb the implanted tips 340. Next a 500 - 1800Å thick silicon nitride layer 342 is deposited onto the oxide layer 341. Silicon nitride layer may be formed by standard CVD deposition methods, including BTBAS deposition techniques. Again, it is advantageous to keep the deposition temperature low. Then, silicon nitride layer 342 and oxide layer 341 are anisotropically etched to form thick spacers 344, as shown in **Figure 3L.** The thick spacers 344 ensure that a subsequent deep implant does not disturb the tip 340 underlying the thick spacers 344. Consequently, the thick spacers 344 should be formed thick and wide enough to prevent the subsequent deep, high dose ion implantation, described below in **Figure 3M,** from overwhelming the portion of the shallow tip 340 underneath the thick spacers 344.

Next, as shown in **Figure 3M,** the substrate 300 is subjected to a deep, high dose implant process to form deep junction source/drain regions 348 in the well region 303. The deep implant includes implanting ions with the same conductivity type impurities used to form the tips 340. For example, if well 303 is of a p-type conductivity, an n-type ion is implanted, whereas for an n-type conductivity well, a p-type ion is implanted. Exemplary n-type ions include arsenic and phosphorous, whereas exemplary p-type ions include boron. At the same time, if the electrically conductive gate electrode 318 comprises polysilicon, the deep implant process can be used to dope the polysilicon in the gate electrode if not previously doped. In one embodiment of the invention, the deep implants 348 are formed to a concentration of between 1x10¹⁹/cm³- 5x10²⁰/cm³ and a depth of approximately 0.15-0.25 micrometers. An activation anneal may be performed to activate the tips 340 and deep implants 348. The anneal may be performed with a RTP at a temperature of between 900° C -1200° C, with 1050° C being preferred, for approximately 10 - 300 seconds, with 20 seconds being preferred, in a nitrogen atmosphere.

Several embodiments of the invention have thus been described. However, those skilled in the art will recognize that the invention is not limited to the embodiments described, but can be practiced with modification and alteration within the scope of the appended claims that follow.

## Claims

1. A transistor comprising:
an oxygen-permeable gate dielectric (319) overlaying a substrate;
an electrically conductive gate electrode (318) over the oxygen-permeable gate dielectric (319), wherein the oxygen-permeable gate dielectric (319) has sidewalls;
a relatively thin oxygen-resistant diffusion barrier (330) having a thickness between 0.2 nm to 30 nm covering the entire sidewall length of the gate dielectric (319), the thin oxygen-resistant diffusion barrier (330) free from diffusible oxygen;
the thin oxygen-resistant diffusion barrier (330) to prevent oxygen from diffusing laterally into the oxygen-permeable gate dielectric (319); a pair of relatively thick sidewall spacers (344); and
source/drain regions (348) and source/drain extensions (340) underlying the thick sidewall spacers (344);
**characterized in that** each of the pair of relatively thick sidewall spacers (344) is formed from two layers wherein one layer (342) having a thickness between 50 nm to 180 nm comprises silicon nitride and one layer (341) having a thickness between 5 nm to 10 nm comprises silicon oxide and wherein the oxide layer (341) is formed adjacent to, and in contact with, the outside edges of the relatively thin oxygen-resistant diffusion barrier (330) and adjacent to, and in contact with, the substrate, wherein the source/drain extensions (340) underly the oxide layer (341) and the oxide layer (341) separates the source/drain extensions from the nitride layer (342).

2. The apparatus of claim 1, wherein the oxygen permeable gate dielectric is a high-k dielectric material.

3. The apparatus of claim 1 or 2, wherein the electrically conductive gate electrode is polysilicon.

4. The apparatus of one of the claims 1 to 3, wherein the relatively thin oxygen-resistant barrier comprises a nitride material.

5. The apparatus of one of the claims 2 to 4, wherein the high-k gate dielectric has a dielectric constant substantially higher than that of silicon dioxide.

6. The apparatus of one of the claims 2 to 5, wherein the high-k gate dielectric comprises a material from the group consisting of metal oxides, ferroelectrics, amorphous metal silicates and silicate oxides, and paralectrics.

## Patentansprüche

1. Transistor, der Folgendes umfaßt:
ein sauerstoffdurchlässiges Gatedielektrikum (319), das über einem Substrat angeordnet ist;
eine elektrisch leitfähige Gateelektrode (318) über dem sauerstoffdurchlässigen Gatedielektrikum (319), wobei das sauerstoffdurchlässige Gatedielektrikum (319) Seitenwände aufweist;
eine relativ dünne sauerstoffbeständige Diffusionssperre (330) mit einer Dicke zwischen 0,2 nm und 30 nm, welche die gesamte Seitenwandlänge des Gatedielektrikums (319) bedeckt, wobei die dünne sauerstoffbeständige Diffusionssperre (330) frei von diffusionsfähigem Sauerstoff ist;
wobei die dünne sauerstoffbeständige Diffusionssperre (330) dazu dient zu verhindern, daß Sauerstoff seitlich in das sauerstoffdurchlässige Gatedielektrikum (319) diffundiert;
ein Paar relativ dicker Seitenwandabstandshalter (344); und
Source/Drain-Regionen (348) und Source/Drain-Verlängerungen (340), die unter den dicken Seitenwandabstandshaltern (344) angeordnet sind;
**dadurch gekennzeichnet, daß** jeder des Paares relativ dicker Seitenwandabstandshalter (344) aus zwei Schichten gebildet ist, wobei eine Schicht (342) mit einer Dicke zwischen 50 nm und 180 nm Siliziumnitrid umfaßt und eine Schicht (341) mit einer Dicke zwischen 5 nm und 10 nm Siliziumoxid umfaßt und wobei die Oxidschicht (341) neben - und in Kontakt mit - den äußeren Rändern der relativ dünnen sauerstoffbeständigen Diffusionssperre (330) und neben - und in Kontakt mit - dem Substrat ausgebildet ist, wobei die Source/Drain-Verlängerungen (340) unter der Oxidschicht (341) angeordnet sind und die Oxidschicht (341) die Source/Drain-Verlängerungen von der Nitridschicht (342) trennt.

2. Vorrichtung nach Anspruch 1, wobei es sich bei dem sauerstoffdurchlässigen Gatedielektrikum um ein dielektrisches Material mit hohem k-Wert handelt.

3. Vorrichtung nach Anspruch 1 oder 2, wobei die elektrisch leitfähige Gateelektrode aus Polysilicium besteht.

4. Vorrichtung nach einem der Ansprüche 1 bis 3, wobei die relativ dünne sauerstoffbeständige Diffusionssperre ein Nitridmaterial umfaßt.

5. Vorrichtung nach einem der Ansprüche 2 bis 4, wobei das Gatedielektrikum mit hohem k-Wert eine Dielektrizitätskonstante aufweist, die wesentlich größer ist als die von Siliziumdioxid.

6. Vorrichtung nach einem der Ansprüche 2 bis 5, wobei das Gatedielektrikum mit hohem k-Wert ein Material aus der Gruppe umfaßt, die aus Metalloxiden, ferroelektrischen Materialien, amorphen Metallsilikaten und Silikatoxiden und paraelektrischen Materialien besteht.

## Revendications

1. Transistor comportant :
un diélectrique de grille perméable à l'oxygène (319) chevauchant un substrat,
une électrode de grille électriquement conductrice (318) sur le diélectrique de grille perméable à l'oxygène (319), le diélectrique de grille perméable à l'oxygène (319) ayant des parois latérales,
une barrière relativement mince de diffusion résistant à l'oxygène (330) ayant une épaisseur comprise entre 0,2 nm et 30 nm recouvrant la longueur entière des parois latérales du diélectrique de grille (319), la barrière mince de diffusion résistant à l'oxygène (330) étant exempte d'oxygène diffusible,
la barrière mince de diffusion résistant à l'oxygène (330) pour empêcher que de l'oxygène se diffuse latéralement dans le diélectrique de grille perméable à l'oxygène (319), une paire d'éléments d'espacement de parois latérales relativement épais (344), et
les régions de source/drain (348) et des extensions de source/drain (340) qui sont sous-jacentes aux éléments d'espacement de parois latérales épais (344),
**caractérisé en ce que** chaque élément d'espacement de la paire d'éléments d'espacement de parois latérales relativement épais (344) est formé de deux couches, une couche (342) ayant une épaisseur comprise entre 50 nm et 180 nm comporte du nitrure de silicium et une couche (341) ayant une épaisseur comprise entre 5 nm et 10 nm comporte de l'oxyde de silicium, et la couche d'oxyde (341) est formée à proximité adjacente des bords extérieurs, et en contact avec ceux-ci, de la barrière relativement mince de diffusion résistant à l'oxygène (330) et à proximité adjacente du substrat, et en contact avec celui-ci, dans lequel les extensions de source/drain (340) sont sous-jacentes à la couche d'oxyde (341) et la couche d'oxyde (341) sépare les extensions de source/drain vis-à-vis de la couche de nitrure (342).

2. Appareil selon la revendication 1, dans lequel le diélectrique de grille perméable à l'oxygène est un matériau diélectrique à valeur k élevée.

3. Appareil selon la revendication 1 ou 2, dans lequel l'électrode de grille électriquement conductrice est du silicium polycristallin.

4. Appareil selon l'une des revendications 1 à 3, dans lequel la barrière résistant à l'oxygène relativement mince comporte un matériau à base de nitrure.

5. Appareil selon l'une des revendications 2 à 4, dans lequel le diélectrique de grille à valeur k élevée a une constante diélectrique essentiellement supérieure à celle du dioxyde de silicium.

6. Appareil selon l'une des revendications 2 à 5, dans lequel le diélectrique de grille à valeur k élevée comporte un matériau choisi parmi le groupe constitué d'oxydes métalliques, ferroélectriques, silicates métalliques amorphes et oxydes de silicate, et paralélectriques.
